# EUROPEAN PATENT APPLICATION

(11) **EP 1 039 524 A2**
(43) Date of publication of application: **27.09.2000**
(21) Application number: 00300919.8
(22) Date of filing: 07.02.2000
(51) Int. Cl.: H01L 21/318, H01L 21/768, C23C 16/34

(54) **Silicon nitride composite HDP/CVD process**

(30) Priority: 05.02.1999 US 245438
(71) Applicant: Applied Materials, Inc., Santa Clara, California 95054 (US)
(72) Inventor: Cheng, Lie-Yea, Palo Alto, California 94301 (US); Chan, Chiu, Foster City, California 94404 (US); Moghadam, Farhad, Saratoga, California 95070 (US)
(74) Representative: Allard, Susan Joyce

(57) **Abstract**

The present invention provides a method for forming a barrier film on a substrate by depositing a first dielectric film, such as a tetra-ethyl-ortho-silicate (TEOS) film, on a substrate and depositing a silicon nitride film over the dielectric film. Preferably, the method further comprises depositing a silicate glass film over the barrier film. The present invention further provides a semiconductor device comprising: a polysilicon substrate; a dielectric film deposited over the polysilicon substrate; a silicon nitride film deposited over the dielectric film; a silicate glass film deposited over the silicon nitride film; and a metal film deposited selectively over the silicate glass film.

## Description

The present invention relates to a method for processing semiconductor substrates. More particularly, the present invention relates to a method of depositing films onto substrates using high density plasma chemical vapor deposition techniques.

Plasma tools used for semiconductor processes such as chemical vapor deposition (CVD), physical vapor deposition (PVD), etching, reactive ion etching and so forth typically employ either inductive coupling or capacitive coupling to strike and maintain a plasma in a chamber. More recently, high density plasma chemical vapor deposition (HDP-CVD) processes have been used to provide a combination of chemical reactions and physical sputtering. HDP-CVD processes promote the dissociation of the reactant gases by the application of radio frequency (RF) energy to the reaction zone proximate the substrate surface, thereby creating a plasma of highly reactive ionic species. The high reactivity of the released ionic species reduces the energy required for a chemical reaction to take place, thus lowering the required temperature for these processes.

The goal in most HDP-CVD processes is to deposit a film of uniform thickness across the surface of a substrate, while also providing good gap fill between lines and other features formed on the substrate. The most widely used HDP-CVD films include silicon oxide and silicon nitride, although other CVD films suitable as insulators, dielectrics, conductors, semiconductors, superconductors and magnetics are known.

With recent decreases in the size of semiconductor devices and corresponding decreases in device feature widths to less than 0.2 µm and aspect ratio greater than 3:1 (ratio of height to width), an advanced deposition process is required to deposit insulators/dielectrics in these smaller features to achieve goals such as reduced current leakage and prevention of crosstalk between conducting lines. The HDP-CVD system is useful for such applications in advanced intermetal dielectrics, shallow and deep trench isolation, and pre-metal dielectrics. HDP-CVD has become the choice system for advanced deposition of dielectric films because the HDP-CVD process is capable of uniform deposition into the smaller device geometries. An example of a HDP-CVD system capable of deposition into such small features is the Ultima™ HDP-CVD System available from Applied Materials, Inc., Santa Clara, California.

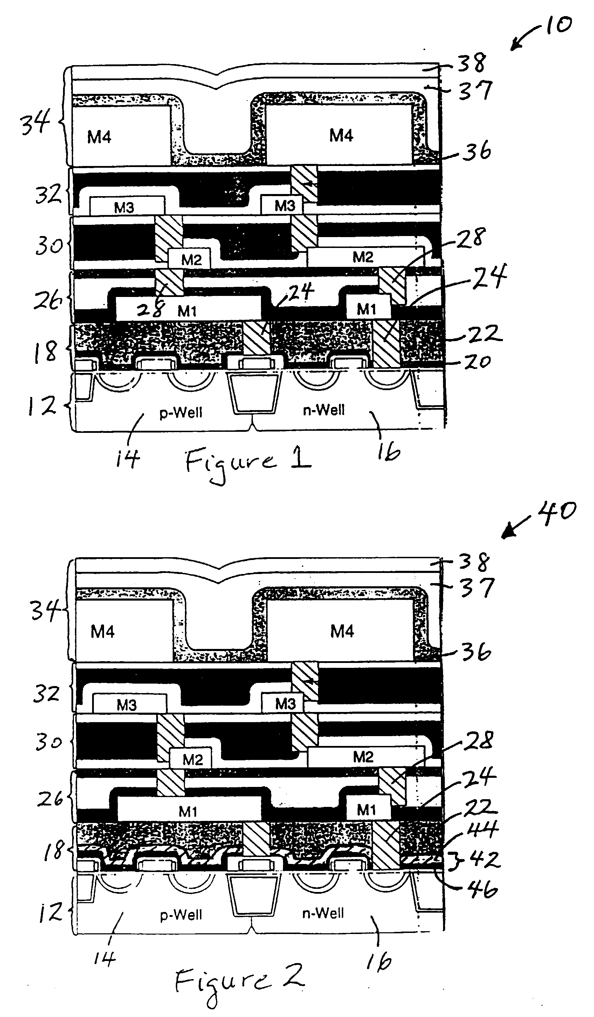

Figure 1 is a schematic cross sectional view of an advanced multilevel logic device 10 having multiple layers of metals and dielectrics. A substrate layer 12 typically comprises polycrystalline silicon (polysilicon) or amorphous silicon. The substrate layer 12 comprises a doped polysilicon p-well 14 and a doped polysilicon n-well 16 forming gates of the semiconductor device. A pre-metal (or poly-metal) dielectric (PMD) layer 18 is deposited over the polysilicon substrate layer 12 and acts as an insulating film between the substrate surface and the first metal layer M1. Typically, the PMD) layer 18 comprises a thin (about 1000 Å thickness) precursor layer of undoped silica glass (USG) 20 and a thick (about 14,000 Å thickness) layer of boron and phosphorous doped silica glass (BPSG) 22 deposited by sub-atmospheric chemical vapor deposition (SACVD). Then the PMD layer 18 is etched at designated areas for deposition of metal interconnects 24 which serve as electrical connections between the substrate layer 12 and the subsequently deposited metal layer. A first metal layer M1 is deposited over the PMD layer 18 and etched to form a desired topography. An intermetal dielectric (IMD) 26, typically comprising an oxide, is deposited over the remaining M1 and then etched for deposition of metal interconnects 28. Subsequent metal layers M2, M3 and M4 separated by IMD layers 30, 32 are similarly deposited and etched. As shown in Figure 1, a planarized passivation layer 34, comprising a bottom plasma enhanced chemical vapor deposition (PECVD) oxide film 36, a middle SACVD oxide film 37 and a top PECVD silicon nitride film 38, serves as a protective layer of the logic device 10.

For an advanced multilevel logic device, HPD-CVD is preferably utilized to produce high quality dielectric layers such as a silicon dioxide dielectric film deposited between metal layers or between a metal layer and a substrate layer. However, one problem resulting from the HDP-CVD process is that a silicon oxide film deposited by the HDP-CVD process contains an undesirable high level of excess hydrogen. This hydrogen rich silicon oxide film results because hydrogen is dissociated from the source gas mixture (for silicon oxide deposition) by the high power plasma at the beginning of the HDP-CVD process. The excess hydrogen in the silicon oxide film diffuses through the silicon oxide layer into an adjacent metal layer and the connecting gate 14 or 16, resulting in undesirable lowered polyload resistivity of the integrated circuit (IC). As shown in Figure 1, excess hydrogen diffuses from the IMD layer 26 deposited by HPD-CVD through the metal interconnects 24 into the polysilicon substrate layer 12 and degrades the gate oxide integrity.

In addition to the lowered polyload resistivity which degrades the performance of the semiconductor device, a device manufactured using a HDP-CVD process suffers from plasma induced damage generated by the high density plasma during processing. Typically, the plasma induced damage lowers the breakdown voltage of a semiconductor device, causing the semiconductor device to suffer from premature failure and unreliable operation.

Therefore, there exists a need for a HDP-CVD process which prevents hydrogen diffusion from a hydrogen rich silicon oxide layer to an adjacent metal layer and thus maintains the desired gate oxide integrity and polyload resistivity. There also exists a need for a HDP-CVD process which minimizes the plasma induced damage generated by the high density plasma on the semiconductor device.

The present invention generally provides a method for enhancing performance of silicon oxide films deposited using HDP-CVD by providing a baffler layer under a silicon oxide layer to prevent diffusion of hydrogen into underlying structures, such as gates, and to minimize plasma induced damage on a semiconductor device by the HDP-CVD process. In accordance with the present invention, a barrier layer comprising a first dielectric film, such as a TEOS film, and a silicon nitride film is first deposited over a substrate, and then, a silicon oxide layer is deposited by HDP-CVD over the barrier layer. By providing a baffler layer of TEOS and silicon nitride, excess hydrogen in the silicon oxide layer generated by the HDP-CVD process cannot diffuse from the oxide layer through the metal layer into the gate. Since the silicon nitride layer prevents hydrogen diffusion from the HDP-CVD oxide layer to the gate, the polyload resistivity of the IC remains at a desirable high level because the integrity of the gate oxide remains in tact.

Another aspect of the present invention provides a semiconductor device produced by the HDP-CVD process which does not suffer from degradation of the gate oxide integrity and plasma induced damage by incorporating a baffler layer as an underlayer in the pre-metal (or poly-metal) dielectric layer.

The present invention further provides a method of producing a semiconductor device comprising: providing a polysilicon substrate; depositing a tetra-ethyl-ortho-silicate (TEOS) film over the polysilicon substrate; depositing a silicon nitride film over the TEOS film; depositing a silicate glass film over the silicon nitride film; etching a via through the silicate glass, the silicon nitride and the TEOS films; depositing a metal interconnect in the via; depositing a metal layer over the silicate glass film; etching away a section of the metal layer; and depositing a silicon oxide film by HDP-CVD over the silicate glass and the metal layer.

So that the manner in which the above recited features, advantages and objects of the present invention are attained can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.
Figure 1 is a schematic cross sectional view of an advanced multilevel logic device 10 having multiple layers of metals and dielectrics;
Figure 2 is a schematic cross sectional view of an advanced multilevel logic device 40 having a barrier layer according to the present invention;
Figure 3 is a graphical comparison of the polyload resistivities of various deposition compositions of the PMD layer in a static random access memory (SRAM); and
Figure 4 is a graphical comparison of the plasma induced damages of various deposition compositions as indicated by the breakdown voltage of the semiconductor device.

The present invention generally provides a method for enhancing performance of silicon oxide films deposited using HDP-CVD by providing a barrier layer under a silicon oxide layer to prevent diffusion of hydrogen into underlying structures such as gates. Figure 2 is a schematic cross sectional view of an advanced multilevel logic device 40 having a barrier layer 42 according to the present invention formed thereon. The advanced multilevel logic device 40, as shown in Figure 2, has a similar structure as the multilevel logic device 10, shown in Figure 1, except that the present invention provides a barrier layer 42 at the interface of the PMD layer and the polysilicon substrate surface. The baffler layer 42 preferably comprises a silicon nitride layer 44 about 500 Å thick deposited between the silicon oxide layer 26 and the polysilicon substrate layer 12. Preferably, a precursor dielectric layer, such as a TEOS layer 46 about 500 Å thick, is first deposited by low pressure chemical vapor deposition (LPCVD) before depositing the silicon nitride film to achieve improved adhesion of the barrier layer 42 to the polysilicon substrate 12. A BPSG film 22 about 14,000 Å thick is deposited by SACVD over the silicon nitride film 44 to complete the PMD layer 18. The PMD layer 18 is then etched appropriately for the desired metal interconnects 24, and then, the next metal layer M1 is deposited over the PMD layer 18. The metal layer M1 is then etched appropriately to a desired topography, and the silicon oxide layer 26 is deposited by HPD-CVD over the remaining metal layer M1 and the exposed PMD layer 18.

The TEOS film 46 can be deposited by a number of methods known in the art, but preferably deposited by LPCVD at a temperature of about 700 °C at a pressure of about 250 mT. The silicon nitride film 44 is preferably deposited by PECVD because PECVD provides a high deposition rate at a lower temperature. Alternatively, the silicon nitride layer can be deposited by other known methods including high temperature furnace LPCVD at a temperature of about 700-800 °C at a pressure of about 200 mT. However, the high temperature furnace LPCVD can change the dopant characteristics of the gates, affect the silicide formed on the polysilicon and cause stress to the semiconductor device.

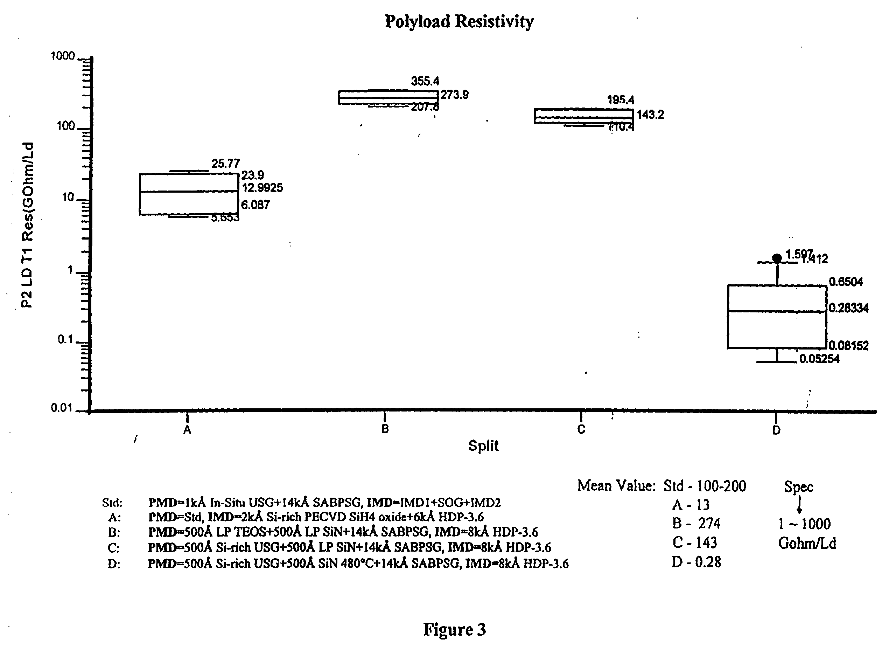

Figure 3 is a graphical comparison of the polyload resistivities of various deposition compositions of the PMD layer in a static random access memory (SRAM) device. The present invention is applicable to other semiconductor devices including, but not limited to, complementary metal oxide semiconductors (CMOS) and dynamic random access memory (DRAM) devices. A standard polyload resistivity for a semiconductor device having a PMD layer comprising 1000 Å USG and 14,000 Å SA BPSG and an IMD layer comprising a first dielectric layer (IMD1), a spin-on glass layer (SOG) and a second dielectric layer (IMD2), (wherein IMD1 comprises 3000 Å PECVD SiO₂, the SOG is 4000 Å thick, and IMD2 comprises 3000 Å PECVD SiO₂) typically has a mean value of about 100 to 200 Gohm/load. Sample A, comprising the same PMD layer with an IMD layer comprising 2000 Å Si-rich PECVD SiH₄ oxide and 6000 Å HDP-3.6 (HDP-3.6 represents deposition using high density plasma wherein the ratio of deposition to sputtering is 3.6), has a mean polyload resistivity of about 13 Gohm/load. Sample B, comprising a PMD layer comprising 500 Å LP TEOS, 500 Å LP SiN and 14,000 Å SA BPSG and an IMD layer comprising 8000 Å HDP-3.6, has a mean polyload resistivity of about 274 Gohm/load. Sample C, comprising a PMD layer comprising 500 Å Sirich USG, 500 Å LP SiN and 14000 Å SA BPSG with an IMD layer comprising 8000 Å HDP-3.6, has a mean polyload resistivity of about. 143 Gohm/load. Sample D, comprising a PMD layer comprising 500 Å Si-rich USG, 500 Å SiN deposited at 480 °C and 14,000 Å SA BPSG with an IMD layer comprising 8000 Å HDP-3.6, has a mean polyload resistivity of about 0.28 Gohm/load. As shown by the comparison in Figure 3, a PMD layer having a barrier layer comprising TEOS and silicon nitride, as the composition of sample B, presents the highest polyload resistivity, indicating superior gate oxide integrity and prevention of degradation by hydrogen diffusion into the gate.

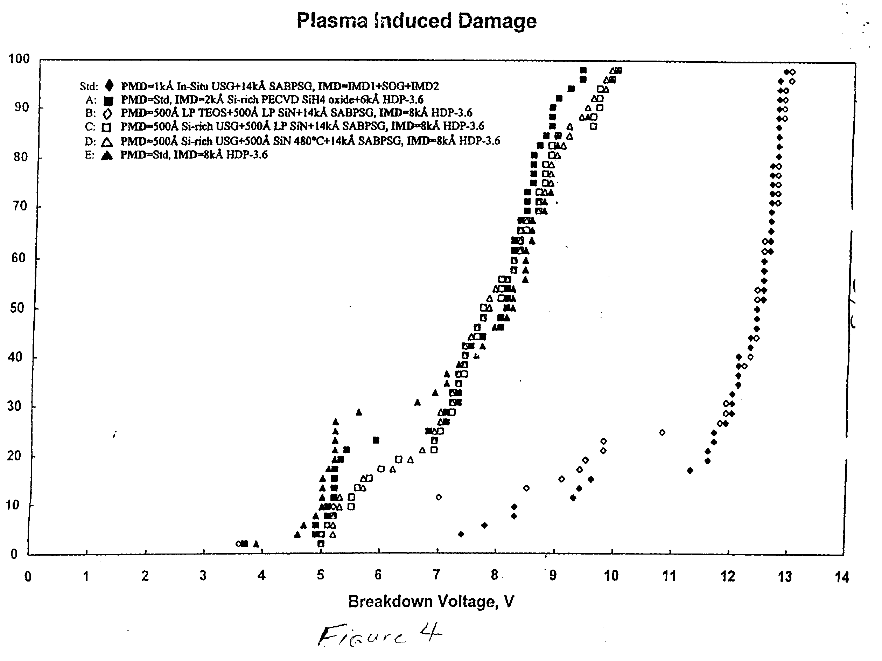

Substrate films deposited by the HDP-CVD process also suffer from plasma induced damage. Plasma induced damage occurs during the HDP-CVD process because a bias charge is built up on the surface of the substrate during the deposition process which allows sputtering of the deposited material in addition to the usual deposition. Plasma induced damage may result in premature IC failure and unreliable operation due to a lower breakdown voltage of the device. The present invention reduces plasma induced damage by providing a barrier layer before depositing a silicon oxide layer by HDP-CVD. Figure 4 is a graphical comparison of the plasma induced damages of various deposition compositions as indicated by the breakdown voltage of the semiconductor device. The breakdown voltage for a semiconductor device which does not utilize HDP-CVD (standard sample composition as described above) is shown as the standard breakdown voltage. Figure 4 also shows the plasma induced damage as indicated by the breakdown voltage of the semiconductor device for the same samples analyzed above for polyload resistivities and an additional sample E which has a PMD layer comprising 1000 Å USG and 14,000 Å SA BPSG and an IMD layer comprising 8000 Å HDP-3.6.

All of the samples utilizing HDP-CVD for depositing the IMD layer suffers from plasma induced damage as shown by the reduced breakdown voltage (to about 9-10 volts) of the semiconductor device except for sample B which has the TEOS and silicon nitride barrier layer in the PMD layer as in sample B. The combination of TEOS and silicon nitride films as a barrier layer provides superior protection against plasma induced damage and yields substantially similar breakdown voltages as the standard sample which does not utilize the HPD-CVD process. The barrier layer may comprise other dielectric materials as well which demonstrate the required baffler properties in a suitable application where HDP-CVD processes are employed.

While the foregoing is directed to the preferred embodiment of the present invention, other and further embodiments of the invention may be devised without departing from the basic scope thereof. The scope of the invention is determined by the claims which follow.

## Claims

1. A baffler film comprising:
a) a first dielectric film; and
b) a silicon nitride film deposited over the first dielectric film.

2. The baffler film of claim 1 wherein the first dielectric film is about 500 Å thick.

3. The baffler film of claim 1 wherein the silicon nitride film is about 500 Å thick.

4. The baffler film of claim 1 wherein the first dielectric film is deposited using low pressure chemical vapor deposition.

5. The baffler film of claim 1 wherein the silicon nitride film is deposited using low pressure chemical vapor deposition.

6. A semiconductor device comprising:
a) a polysilicon substrate;
b) a dielectric film deposited over the polysilicon substrate;
c) a silicon nitride film deposited over the dielectric film;
d) a silicate glass film deposited over the silicon nitride film; and
e) a metal film deposited selectively over the silicate glass layer.

7. The semiconductor device of claim 6 further comprising:
f) an electrical interconnect connecting the metal film.

8. The semiconductor device of claim 7 further comprising:
g) a silicon oxide film deposited over the metal film using high density plasma chemical vapor deposition.

9. The semiconductor device of claim 6 wherein the dielectric film comprises a TEOS film about 500 Å thick.

10. The semiconductor device of claim 6 wherein the silicon nitride film is about 500 Å thick.

11. A method of producing a semiconductor device on a substrate, comprising:
a) depositing a first dielectric film over the substrate;
b) depositing a silicon nitride film over the dielectric film;
c) depositing a silicate glass film over the silicon nitride film;
d) etching a via through the silicate glass, the silicon nitride and the dielectric films;
e) depositing a metal interconnect in the via;
f) depositing a metal film over the silicate glass film;
g) etching away a section of the metal film to expose a section of the silicate glass film; and
h) depositing a silicon oxide film over the silicate glass film and the metal film using high density plasma chemical vapor deposition techniques.

12. The method of claim 11 wherein the dielectric film comprises a TEOS film about 500 Å thick.

13. The method of claim 11 wherein the silicon nitride film is about 500 Å thick.

14. The method of claim 11 wherein the silicate glass is about 14 kÅ thick.

15. The method of claim 11 wherein the silicate glass is a boron and phosphorus doped silicate glass deposited through sub-atmospheric chemical vapor deposition.

16. The method of claim 11 wherein the silicon nitride film is deposited through plasma enhanced chemical vapor deposition.

17. The method of claim 11 wherein the silicon nitride film is deposited through low pressure chemical vapor deposition.

18. The method of claim 11 wherein the dielectric film is deposited through plasma enhanced chemical vapor deposition.

19. The method of claim 11 wherein the dielectric film is deposited through low pressure chemical vapor deposition.
